(19) Europäisches Patentamt
European Patent Office
Office européen des brevets

(11) EP 2 396 274 B1

(12) **EUROPEAN PATENT SPECIFICATION**

(45) Date of publication and mention
of the grant of the patent:
**07.08.2019 Bulletin 2019/32**

(21) Application number: **10704182.4**

(22) Date of filing: **12.02.2010**

(51) Int Cl.:
**B81B 3/00** $^{(2006.01)}$  **B06B 1/02** $^{(2006.01)}$

(86) International application number:
**PCT/GB2010/050241**

(87) International publication number:
**WO 2010/092406 (19.08.2010 Gazette 2010/33)**

(54) **MEMS DEVICE WITH LEAKAGE PATH**

MEMS-VORRICHTUNG MIT LECKWEG

DISPOSITIF MEMS AVEC UN CHEMIN DE FUITE

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(30) Priority: **13.02.2009 GB 0902480**

(43) Date of publication of application:
**21.12.2011 Bulletin 2011/51**

(73) Proprietor: **Cirrus Logic International
Semiconductor Limited
Edinburgh EH3 9EG (GB)**

(72) Inventors:
• **JENKINS, Colin, Robert
Livingston EH54 7ET (GB)**
• **HOEKSTRA, Tsjerk, Hans
Balerno EH14 7JT (GB)**

• **LAMING, Richard, Ian
Edinburgh EH10 6BY (GB)**

(74) Representative: **Haseltine Lake Kempner LLP
Redcliff Quay
120 Redcliff Street
Bristol BS1 6HU (GB)**

(56) References cited:
**WO-A1-00/31819**

• **ARNEY S ET AL: "Effects of Electrical Leakage
Currents on MEMS Reliability and Performance",
IEEE TRANSACTIONS ON DEVICE AND
MATERIALS RELIABILITY, IEEE SERVICE
CENTER, PISCATAWAY, NJ, US, vol. 4, no. 2, 1
June 2004 (2004-06-01), pages 198-207,
XP011115743, ISSN: 1530-4388, DOI:
DOI:10.1109/TDMR.2004.826350**

EP 2 396 274 B1

## Description

Field of the invention

This invention relates to a MEMS device and process, and in particular to a MEMS device and process relating to a transducer, and in particular a capacitive transducer such as a MEMS capacitive microphone.

Background of the invention

Consumer electronics devices are continually getting smaller and, with advances in technology, are gaining ever increasing performance and functionality. This is clearly evident in the technology used in consumer electronic products such as, for example, mobile phones, laptop computers, MP3 players and personal digital assistants (PDAs). Requirements of the mobile phone industry, for example, are driving components to become smaller with higher functionality and reduced cost. For example, some mobile phones now require multiple microphones for noise cancelling, or accelerometers to allow inertial navigation, while maintaining or reducing the small form factor and aiming at a similar total cost to previous generation phones.

This has encouraged the emergence of miniature transducers. For example, in respect to speech applications, initially electret microphones were used to capture speech, but more recently micro-electrical-mechanical (MEMS) transducers have been introduced. MEMS transducers may be used in a variety of applications including, but not limited to, pressure sensing, ultrasonic scanning, acceleration monitoring and signal generation. Traditionally such MEMS transducers are capacitive transducers some of which comprise one or more membranes with electrodes for read-out/drive deposited on the membranes and/or a substrate. Relative movement of these electrodes modulates the capacitance between them, which then has to be detected by associated electronic circuitry such as sensitive electronic amplifiers.

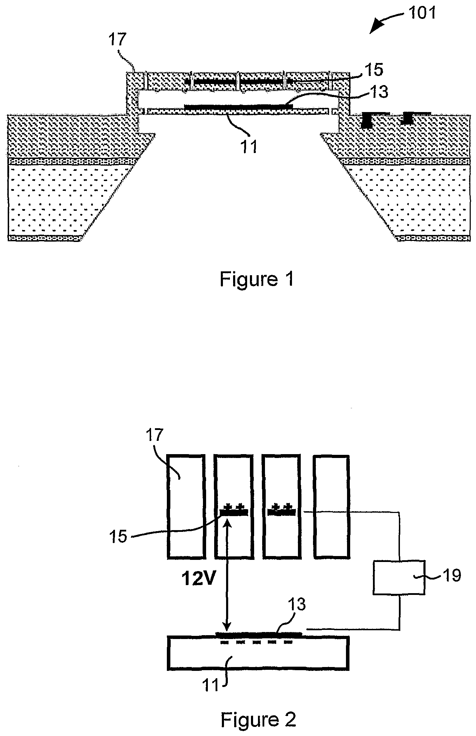

Figure 1 shows a schematic diagram of a capacitive microphone device. The capacitive microphone device comprises a flexible membrane 11 that is free to move in response to pressure differences generated by sound waves. A first electrode 13 is mechanically coupled to the flexible membrane 11, and together they form a first capacitive plate of the capacitive microphone device. A second electrode 15 is mechanically coupled to a generally rigid structural layer or back-plate 17, which together form a second 2 capacitive plate of the capacitive microphone device. The membrane 11 and back-plate 17 are formed from a dielectric material, for example silicon nitride.

The flexible membrane 11 is free to move in response to a stimulus, for example sound or pressure waves. This movement of the flexible membrane causes the capacitance between the first and second electrodes 13, 15 to change. In use the capacitive microphone device is typically arranged to drive into a high impedance circuit, such that the charge on the capacitor does not change significantly. Therefore, the change in the capacitance of the transducer due to the stimulus results in a change 11V in the voltage across the transducer capacitance. This change in voltage can be detected and processed to provide an electrical output signal.

Figure 2 shows the membrane 11 and back-plate 17 of Figure 1 in greater detail, together with their respective electrodes 13 and 15. The first and second electrodes 13, 15 are biased by a voltage source 19, for example a charge pump providing a bias voltage of 12v.

As can be seen from Figure 2, the second electrode 15 is formed within the back-plate 17 such that it is surrounded by dielectric material. The electrode is encapsulated within the layer of dielectric material, i.e. the back-plate 17, for a number of reasons.

Firstly, by forming the electrode 15 within the back-plate 17 the dielectric material acts to protect the electrode 15 from harmful environmental effects. For example, the dielectric material prevents the metal electrode 15 from corroding or oxidising.

Secondly, by forming the electrode 15 within the back-plate 17 the fabrication process is improved. This is because it is easier to deposit a metal electrode onto silicon nitride than it is to deposit a metal electrode onto polyimide (polyimide being typically used as a sacrificial layer during the fabrication process for forming the air gap that exists between the back-plate 17 and the membrane 11).

Thirdly, encapsulating the electrode 15 within the back-plate 17 has the effect of lowering the stiction forces that exist when the membrane 11 is deflected towards the back-plate 17.

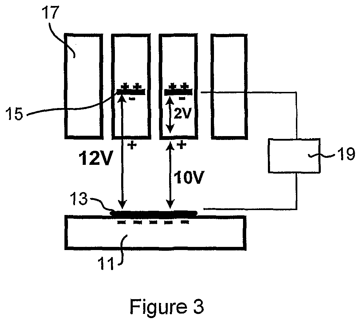

A disadvantage of the arrangement shown in Figure 2 is that the dielectric layer under the electrode 15 of the back-plate 17 is susceptible to charging, especially for a dielectric layer comprising silicon nitride. This is particularly the case when the resistance of the air gap between the first and second electrodes 13, 15 is reduced, for example in a humid atmosphere. This causes ions to drift through the air gap and accumulate onto the lower surface of the back-plate 17, causing a charge accumulation on the lower surface of the dielectric layer. As can be seen from Figure 3, a positive charge accumulates on the upper surface of the second electrode 15, while a negative charge accumulates on the lower surface of the first electrode 13.

The charge on the silicon nitride layer can build up to the maximum of the applied voltage (e.g. 12V). This has the disadvantage of reducing the sensitivity of the MEMS device.

In the example shown in Figure 3 a 2v charge in the silicon nitride layer (i.e. between the underside of the second electrode 15 and the lower surface of the back-plate 17) leads to a sensitivity loss of:

$$20 \log (10/12) = 1.6 \text{dB}$$

Similarly, a 6V charge in the silicon nitride layer gives an attenuation of 6dB, and a 9V charge an attenuation of 12dB.

Any charge accumulated in the silicon nitride layer has a very long decay time, possibly days or weeks, which is obviously much longer than the response time of the MEMS device.

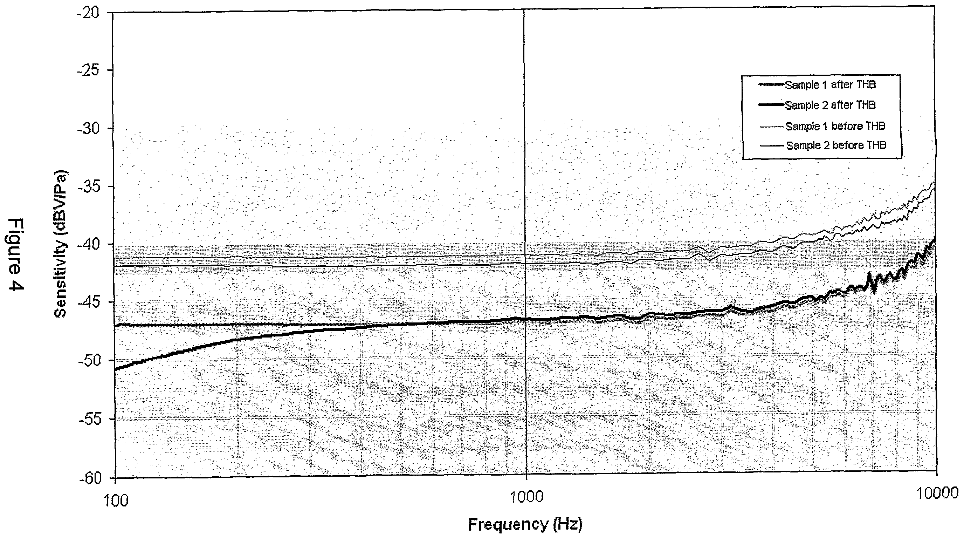

Figure 4 is a graph illustrating the sensitivity reduction on two microphones after temperature humidity bias testing (at 85C/85%).

An example of background art can be found in a paper by Arney et al, entitled "Effects of Electrical Leakage Currents on MEMS Reliability and Performance, IEEE Transactions on device and materials reliability, IEEE service center, Piscataway, NJ, US, vol. 4, no. 2, 1 June 2004, pages 198-207, XP011115743, ISSN: 1530-4388.

Summary of the invention

It is an aim of the present invention to provide a MEMS device, and a method of fabricating a MEMS device, that reduces or removes the undesired effect mentioned above.

According to an aspect of the invention, there is provided a micro-electrical-mechanical system (MEMS) transducer comprising: a layer of dielectric material; an electrode formed in the layer of dielectric material such that the layer of dielectric material comprises a first dielectric layer and a second dielectric layer provided on opposite sides of the electrode; wherein a region of the layer of the dielectric material is adapted such that it comprises a first impedance in a first plane that lies substantially orthogonal to the plane of the first layer, the first plane comprising a plane that lies substantially axially between a surface of the electrode and a surface of a second electrode forming part of a capacitive transducer, and a second impedance in a second plane, the second plane comprising a plane that lies substantially orthogonal to the first plane, wherein the first impedance is reduced compared to the second impedance, and wherein, when biased during use, the region of dielectric material operates in a tunnelling mode of operation to provide a leakage path which, in use, removes unwanted charge from the layer of dielectric material.

According to another aspect of the invention, there is provided a method of forming a micro-electrical-mechanical system (MEMS) transducer, the method comprising the steps of: depositing a first layer of dielectric material; depositing an electrode; depositing a second layer of dielectric material such that the first layer of dielectric material and the second layer of dielectric material are provided on opposite sides of the electrode; wherein the step of depositing the first layer of dielectric material comprises forming a first impedance in a first plane that lies substantially orthogonal to the plane of the first layer, and a second impedance in a second plane that lies substantially parallel to the plane of the first layer, wherein the first impedance is reduced compared to the second impedance such that, when biased during use, the first layer of dielectric material operates in a tunnelling mode of operation to provide a leakage path which, in use, removes unwanted charge from the first layer of dielectric material.

Brief description of the drawings

For a better understanding of the invention, and to show more clearly how it may be carried into effect, reference will now be made, by way of example only, to the accompanying drawings in which:

Figure 1 is schematic cross-sectional view of a MEMS microphone according to the prior art;

Figure 2 shows the back-plate, membrane and associated electrodes of Figure 1 in greater detail;

Figure 3 illustrates the accumulation of charge in the device of Figures 1 and 2;

Figure 4 is a graph illustrating the sensitivity reduction on two microphones after temperature humidity bias testing;

Figure 5 shows a MEMS device according to an embodiment of the invention;

Figure 6 shows the electrical properties of silicon nitride, and a Fowler-Nordheim plot;

Figure 7 illustrates measured conductivities through 50nm of silicon nitride using different materials;

Figure 8 illustrates the charge decay of silicon nitride having helium depletion;

Figure 9 illustrates the charge decay of silicon nitride having silicon enrichment; and

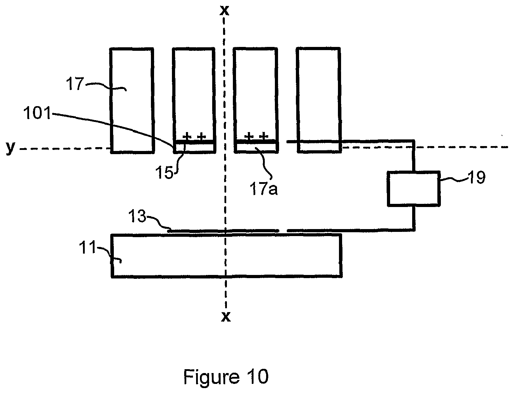

Figure 10 shows a further embodiment of the present invention.

Detailed description of the preferred embodiment

The invention will be described in relation to a MEMS transducer in the form of a MEMS capacitive microphone. It will be appreciated, however, that the invention is equally applicable to any form of capacitive transducer including, but not limited to pressure sensors, ultrasonic transducers, acceleration monitoring and signal generation transducers.

Furthermore, although the invention will be described in relation to a back-plate of a MEMS device, it will be appreciated that the invention is equally applicable to any other dielectric layer of a MEMS device having an associated electrode, for example a membrane having a layer of dielectric material between its electrode and the other electrode of the capacitive transducer, for example if the electrode 13 was provided on the underside of the membrane 11, or encapsulated therein.

It is also noted that, although the embodiments of the invention are described in relation to a back-plate formed from silicon nitride, it will be appreciated that the invention is applicable with other dielectric materials.

According to the invention a leakage path is provided in a region of the back-plate for preventing or removing any unwanted charge from accumulating in the back-plate.

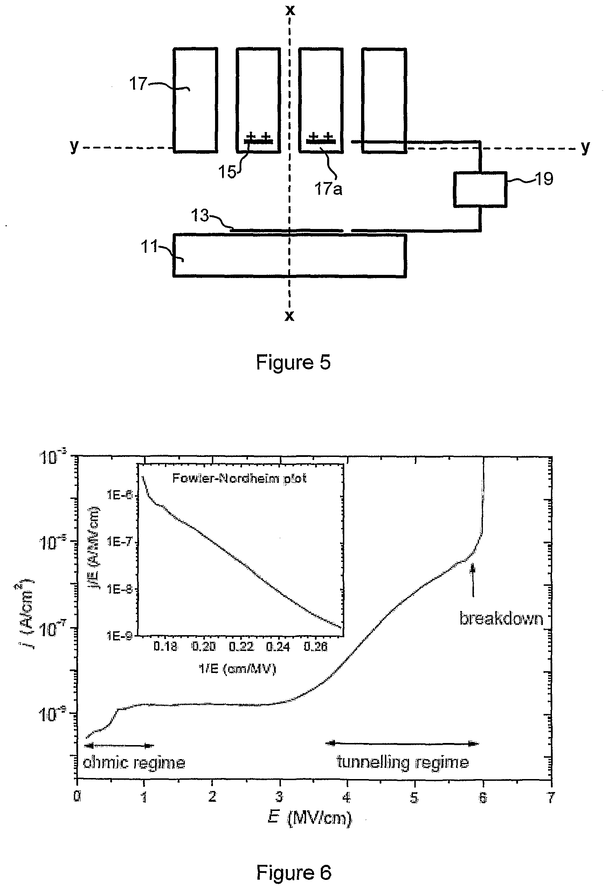

Referring to Figure 5, according to one embodiment the thickness of the back-plate is reduced on the underside of the electrode 15, Le. in a region 17a of the back-plate. It will be appreciated that the term "underside" refers to the side of the electrode which faces the other electrode of the capacitive transducer, i.e. the side that faces electrode 13. Reducing the thickness of the back-plate 17 in this region 17a has the effect of lowering the impedance of the dielectric layer between the electrodes 15, 13. In other words, the impedance of the dielectric layer under the electrode 15 is reduced in a plane that lies along an axis X-X, this axis X-X being an axis that runs in the general direction from one electrode 15 to another electrode 13.

It is noted that the back-plate in a MEMS device such as that shown in Figure 5 may be formed by depositing a first layer of silicon nitride, depositing the electrode 15 on a portion of the first layer of silicon nitride, and depositing a second layer of silicon nitride over the electrode 15 and first layer of silicon nitride, thereby encapsulating the electrode with silicon nitride to form the back-plate 17. The first layer of silicon nitride may be deposited over a sacrificial layer (not shown), which is deposited during the fabrication process in order to support the formation of the back-plate 17, but then removed to provide the air gap between the back-plate 17 and the membrane 11. Therefore, the layer on the underside of the back-plate 17 can be reduced in thickness by depositing the first layer with reduced thickness compared to the second layer.

According to one embodiment, the thickness of the dielectric layer in the region 17a is reduced such that the dielectric layer behaves in a tunnelling mode of operation, such that when the capacitive transducer is biased during use any unwanted charge stored in the region 17a of the back-plate is removed.

Figure 6 shows a Fowler-Nordheim plot illustrating the electrical properties of silicon nitride, including an ohmic region and a tunnelling region. The silicon nitride layer on the underside of the electrode 15 is deposited such that the silicon nitride layer is adapted to operate in the tunnelling mode.

This enables a current to flow through the silicon nitride layer which discharges any accumulated charge, thus making the air gap the key insulator in the capacitive circuit.

It will be appreciated that reducing the thickness of the back-plate on the underside of the electrode to a bare minimum thickness can have an undesired effect of reducing the insulating effect of the dielectric of the capacitive microphone device, which could lead to device collapse and short circuit.

Therefore, according to another embodiment, one or more parameters of the silicon nitride layer and/or one or more parameters associated with the deposition of the silicon nitride layer are altered to provide a region that has improved charge removal properties for a given thickness of silicon nitride. Preferably this is done in addition to reducing the thickness as mentioned above. However, it is noted that the reduction in the thickness of the silicon nitride can be altered in relation to what other parameters are changed in the composition of the silicon nitride, or its deposition, thus enabling the thickness to be reduced by less than would otherwise be needed.

The parameters are selected such that the dielectric layer underneath the electrode has a first resistance in a first direction X-X (i.e. between the surface of the electrode and the corresponding outer surface of the back-plate), and a second resistance in a second direction Y-Y (Le. along the body of the silicon nitride layer). A very high sheet resistance is maintained in the nitride layer in direction Y-Y in order to prevent undesirable leakage currents from the 12V charge pump input, (which would otherwise cause noise at the microphone output).

A key parameter is controlling the layer thickness and separation of the conductive features such that the nitride layer appears to be resistive through its thickness, but is a near perfect insulator over the sheet resistance.

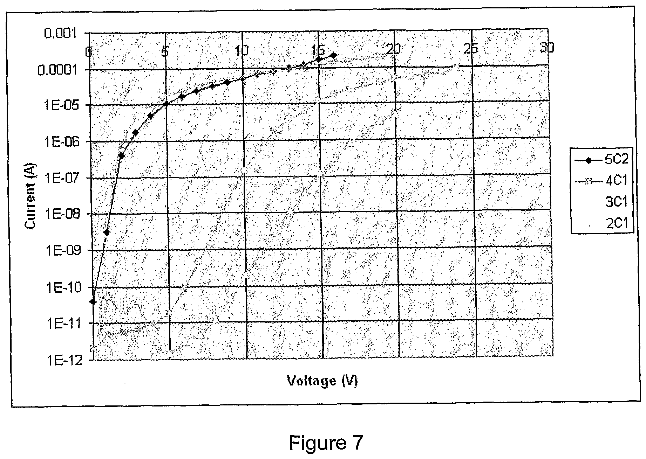

Figure 7 shows current conduction through 50mm thick nitride layers of different compositions. An ohmic conductive region can be seen for all the materials where the current is greater than 1 e-5A. The material should be controlled so that a measure of conductivity is always present through the sheet (for example, material 4C1 in Fig 7), but where the conductivity across the sheet is minimised through aspect ratio control and material choice.

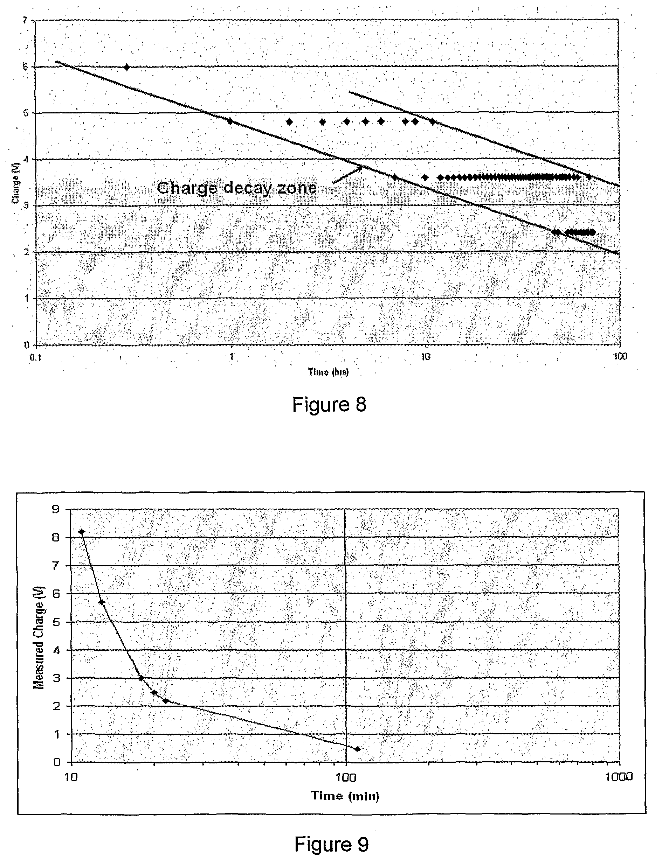

Silicon Nitrides with different deposition properties have been measured for charge decay using microphone die with 300nm nitride below the back-plate electrode. Standard silicon nitride has been found to have very long charge decay times extending to weeks or months. Silicon nitrides deposited using helium depletion have been seen to decay to 2.5V in about 100 hours, as shown in Figure 8. Silicon nitrides deposited which are 1.3% silicon rich have seen charge decay to 2.5V in about 20 minutes, as shown in Figure 9.

The electrodes 15, 13 are preferably placed in a central region of the back-plate and membrane, i.e. rather than over the entire surface of the membrane or back-plate, thus having the advantage of maximising the leakage path via the sidewalls of the device.

In the embodiments described above the sound ports are shown passing through the dielectric material and the electrode. It will be appreciated, however, that the invention is equally applicable to a device where the sound ports do not pass through the electrode itself.

In the embodiment of Figure 5, i.e. having sound ports passing through the electrode, it can be seen that the electrode is encapsulated within the dielectric material. In other words, the edges of the electrode 15 are not exposed on the inner surfaces of the sound ports. This is achieved by etching holes having a first diameter in the electrode 15 prior to the dielectric layer being formed over the electrode 15, such that when the smaller diameter sound ports are subsequently etched through the back-plate, the electrode 15 is not exposed on any of the inner surfaces of the sound ports.

However, according to another embodiment of the invention, the electrode is not etched prior to forming the layer of dielectric over the electrode. Thus, when the sound ports are etched through the dielectric material and the electrode, the electrode will be exposed on the inner surface of the sound ports. Although this has the disadvantage of not providing an environmental barrier, it has the advantage of providing a surface leakage path 101 between the edge of the exposed electrode and the lower surface of the back-plate.

According to another embodiment, the device can be configured such that certain sound ports have the electrode exposed, while other sound ports have the sound port encapsulated. This has the advantage of enabling the effect of the leakage path to be controlled more accurately. The variation in the number of sound ports having the electrode exposed can be determined during the step of etching holes in the electrode, i.e. prior to the top layer of the back-plate being formed. For example, some holes in the electrode can be configured to have diameters that are larger than the sound ports (such that the electrode does not become exposed when the sound ports are subsequently etched), while other holes in the electrode can be etched to have diameters that match the diameters of the sound ports (or not etched at all).

It is noted that the invention may be used in a number of applications. These include, but are not limited to, consumer applications, medical applications, industrial applications and automotive applications. For example, typical consumer applications include laptops, mobile phones, PDAs and personal computers. Typical medical applications include hearing aids. Typical industrial applications include active noise cancellation. Typical automotive applications include hands-free sets, acoustic crash sensors and active noise cancellation.

It should be noted that the above-mentioned embodiments illustrate rather than limit the invention, and that those skilled in the art will be able to design many alternative embodiments without departing from the scope of the appended claims. The word "comprising" does not exclude the presence of elements or steps other than those listed in a claim, "a" or "an" does not exclude a plurality, and a single feature or other unit may fulfil the functions of several units recited in the claims. Any reference signs in the claims shall not be construed so as to limit their scope.

**Claims**

1. A micro-electrical-mechanical system (MEMS) transducer comprising:

   a layer of dielectric material (17); **characterised by**
   an electrode (15) formed in the layer of dielectric material (17), such that the layer of dielectric material comprises a first dielectric layer and a second dielectric layer provided on opposite sides of the electrode;
   wherein a region (17a) of the layer of the dielectric material is adapted such that it comprises:

      a first impedance in a first plane that lies substantially orthogonal to the plane of the first layer, the first plane comprising a plane that lies substantially axially between a surface of the electrode and a surface of a second electrode forming part of a capacitive transducer; and
      a second impedance in a second plane, the second plane comprising a plane that lies substantially orthogonal to the first plane;
      wherein the first impedance is reduced compared to the second impedance; and
      wherein, when biased during use, the region of dielectric material operates in a tunnelling mode of operation, to provide a leakage path which, in use, removes unwanted charge from the layer of dielectric material (17).

2. A MEMS transducer as claimed in claim 1, wherein the region (17a) is provided in the first dielectric layer, between a first side of the electrode (15) and a corresponding outer surface of the first dielectric layer, and wherein the thickness of the region (17a) is reduced compared to a second region, the second region provided in the second dielectric layer, between the opposite side of the electrode (15) and a corresponding outer surface of the second dielectric material.

3. A MEMS transducer as claimed in claim 1 or 2, wherein the composition of the region is different to another region in the layer of dielectric material.

4. A MEMS transducer as claimed in any one of the preceding claims, further comprising one or more sound ports provided in the dielectric material, the sound ports providing an opening between a first outer surface of the dielectric layer and a second outer surface of the dielectric material.

5. A MEMS transducer as claimed in claim 4, wherein at least one sound port passes through the electrode (15), and wherein a part of the electrode is exposed at an inner surface of a sound port, the exposed part of the electrode, in use, acting to remove unwanted charge.

6. A method of forming a micro-electrical-mechanical system (MEMS) transducer, the method comprising the steps of:

depositing a first layer of dielectric material;
depositing an electrode; **characterised by** depositing a second layer of dielectric material, such that the first layer of dielectric material and second layer of dielectric material are provided on opposite sides of the electrode; and wherein the step of depositing the first layer of dielectric material comprises forming:

a first impedance in a first plane that lies substantially orthogonal to the plane of the first layer; and
a second impedance in a second plane that lies substantially parallel to the plane of the first layer;
wherein the first impedance is reduced compared to the second impedance such that, when biased during use, the first layer of dielectric material operates in a tunnelling mode of operation to provide a leakage path which, in use, removes unwanted charge from the first layer of dielectric material.

7. A method as claimed in claim 6, wherein the step of depositing the first layer of dielectric material comprises the step of depositing a layer of dielectric material having a reduced thickness compared to the second layer of dielectric material.

8. A method as claimed in claim 6 or 7, wherein the composition of the first layer is different to the composition of the second layer.

9. A method as claimed in any one of claims 6 to 8, further comprising the step of forming one or more sound ports that extend through the first and second layers of dielectric material, wherein the step of forming one or more sound ports comprises forming at least one sound port through the electrode, and wherein the step of forming a sound port through the electrode comprises exposing a part of the electrode, the exposed part of the electrode, in use, acting to remove unwanted charge.

10. An electronic device, or a communications device, or a portable telephone, or an audio device, or a computer device, or a vehicle, or a medical device, or an industrial device comprising a micro-electrical-mechanical system (MEMS) transducer as claimed in anyone of claims 1 to 5.

**Patentansprüche**

1. MEMS-Transducer (MEMS: mikroelektromechanisches System), umfassend:

eine Schicht aus einem dielektrischen Material (17), **gekennzeichnet durch**
eine Elektrode (15), die in der Schicht aus einem dielektrischen Material (17) ausgebildet ist, so dass die Schicht aus einem dielektrischen Material eine erste dielektrische Schicht und eine zweite dielektrische Schicht umfasst, die auf gegenüberliegenden Seiten der Elektrode bereitgestellt sind,
wobei ein Gebiet (17a) der Schicht aus dem dielektrischen Material derart ausgelegt ist, dass es umfasst:

eine erste Impedanz in eiere ersten Ebene, die im Wesentlichen senkrecht zur Ebene der ersten Schicht liegt, wobei die erste Ebene eine Ebene umfasst, die im Wesentlichen axial zwischen einer Fläche der Elektrode und einer Fläche einer zweiten Elektrode liegt, die einen Teil eines kapazitiven Transducers bilden, und
eine zweite Impedanz in einer zweiten Ebene, wobei die zweite Ebene eine Ebene umfasst, die im Wesentlichen senkrecht zur ersten Ebene liegt,
wobei die erste Impedanz im Vergleich mit der zweiten Impedanz reduziert ist, und wobei, wenn beim Gebrauch vorgespannt, das Gebiet des dielektrischen Materials in einem Tunnelbetriebsmodus arbeitet, um einen Leckpfad bereitzustellen, der im Gebrauch unerwünschte Ladung von der Schicht aus einem dielektrischen Material (17) entfernt.

2. MEMS-Transducer nach Anspruch 1,
wobei das Gebiet (17a) in der ersten dielektrischen Schicht zwischen einer ersten Seite der Elektrode (15) und einer entsprechenden Außenfläche der ersten dielektrischen Schicht bereitgestellt ist, und wobei die Dicke des Gebiets (17a) im Vergleich mit einem zweiten Gebiet reduziert ist, wobei das zweite Gebiet in der zweiten dielektrischen Schicht zwischen der gegenüberliegenden Seite der Elektrode (15) und einer entsprechenden Außenfläche des zweiten dielektrischen Materials bereitgestellt ist.

3. MEMS-Transducer nach Anspruch 1 oder 2, wobei die Zusammensetzung des Gebiets von einem anderen Gebiet in der Schicht aus einem dielektrischen Material verschieden ist.

4. MEMS-Transducer nach einem der vorhergehenden Ansprüche, der ferner eine oder mehrere Schallöffnungen umfasst, die in dem dielektrischen Material bereitgestellt sind, wobei die Schallöffnungen eine Öffnung zwischen einer ersten Außenfläche der dielektrischen Schicht und einer zweiten Außenfläche des dielektrischen Materials bereitstellen.

5. MEMS-Transducer nach Anspruch 4, wobei zumindest eine Schallöffnung durch die Elektrode (15) verläuft, und wobei ein Teil der Elektrode an einer Innenfläche einer Schallöffnung freigelegt ist, wobei der freigelegte Teil der Elektrode beim Gebrauch dahingehend arbeitet, unerwünschte Ladung zu entfernen.

6. Verfahren zum Ausbilden eines MEMS-Transducers (MEMS: mikroelektromechanisches System), wobei das Verfahren die folgenden Schritte umfasst:

   Abscheiden einer ersten Schicht aus einem dielektrischen Material,
   Abscheiden einer Elektrode, **gekennzeichnet durch**:
   Abscheiden einer zweiten Schicht aus einem dielektrischen Material, so dass die erste Schicht aus einem dielektrischen Material und die zweite Schicht aus einem dielektrischen Material auf gegenüberliegenden Seiten der Elektrode bereitgestellt werden, und wobei der Schritt des Abscheidens der ersten Schicht aus einem dielektrischen Materials ein Ausbilden von Folgendem umfasst:

      einer ersten Impedanz in einer ersten Ebene, die im Wesentlichen senkrecht zur Ebene der ersten Schicht liegt, und
      einer zweiten Impedanz in einer zweiten Ebene, die im Wesentlichen parallel zur Ebene der ersten Schicht liegt,
      wobei die erste Impedanz im Vergleich mit der zweiten Impedanz reduziert ist, so dass, wenn beim Gebrauch vorgespannt, die erste Schicht aus einem dielektrischen Material in einem Tunnelbetriebsmodus arbeitet, um einen Leckpfad bereitzustellen, der im Gebrauch unerwünschte Ladung von der ersten Schicht aus einem dielektrischen Material entfernt.

7. Verfahren nach Anspruch 6, wobei der Schritt des Abscheidens der ersten Schicht aus einem dielektrischen Material den Schritt des Abscheidens einer Schicht aus einem dielektrischen Material umfasst, die im Vergleich mit der zweiten Schicht aus einem dielektrischen Material eine reduzierte Dicke aufweist.

8. Verfahren nach Anspruch 6 oder 7, wobei die Zusammensetzung der ersten Schicht von der Zusammensetzung der zweiten Schicht verschieden ist.

9. Verfahren nach einem der Ansprüche 6 bis 8, das ferner den Schritt des Ausbildens einer oder mehrerer Schallöffnungen umfasst, die sich durch die erste und die zweite Schicht aus einem dielektrischen Material erstrecken, wobei der Schritt des Ausbildens einer oder mehrerer Schallöffnungen ein Ausbilden von zumindest einer Schallöffnung durch die Elektrode umfasst, und wobei der Schritt des Ausbildens einer Schallöffnung durch die Elektrode ein Freilegen eines Teils der Elektrode umfasst, wobei der freigelegte Teil der Elektrode beim Gebrauch dahingehend arbeitet, unerwünschte Ladung zu entfernen.

10. Elektronische Vorrichtung oder Kommunikationsvorrichtung oder tragbares Telefon oder Audiovorrichtung oder Rechnervorrichtung oder Fahrzeug oder medizinische Vorrichtung oder industrielle Vorrichtung, die/das einen MEMS-Transducer (MEMS: mikroelektromechanisches System) nach einem der Ansprüche 1 bis 5 umfasst.

**Revendications**

1. Transducteur à système mécanique micro-électrique (MEMS) comprenant :

   une couche de matériau diélectrique (17) ; **caractérisé par**
   une électrode (15) formée dans la couche de matériau diélectrique (17), de telle façon que la couche de matériau diélectrique comprend une première couche diélectrique et une deuxième couche diélectrique disposées sur des côtés opposés de l'électrode ;
   dans lequel une région (17a) de la couche de matériau diélectrique est adaptée de manière à comprendre :

      une première impédance dans un premier plan s'étendant substantiellement orthogonalement au plan de la première couche, le premier plan comprenant un plan s'étendant substantiellement axialement entre une surface de l'électrode et une surface d'une deuxième électrode faisant partie d'un transducteur capacitif ; et

une deuxième impédance dans un deuxième plan le deuxième plan comprenant un plan d'étendant substantiellement orthogonalement au premier plan ;

dans lequel la première impédance est réduite par rapport à la deuxième impédance ; et

dans lequel, lorsqu'elle est sollicitée pendant l'utilisation, la région de matériau diélectrique fonctionne dans un mode de fonctionnement de tunnelisation, pour fournir un chemin de fuite éliminant une charge indésirable de la couche de matériau diélectrique (17) lorsqu'il est utilisé.

2. Transducteur MEMS selon la revendication 1, dans lequel la région (17a) est disposée dans la première couche diélectrique, entre un premier côté de l'électrode (15) et une surface extérieure correspondante de la première couche diélectrique, et dans lequel l'épaisseur de la région (17a) est réduite par rapport à une deuxième région, la deuxième région étant disposée dans la deuxième couche diélectrique, entre le côté opposé de l'électrode (15) et une surface extérieure correspondante du deuxième matériau diélectrique.

3. Transducteur MEMS selon la revendication 1 ou 2, dans lequel la composition de la région est différente de celle d'une autre région dans la couche de matériau diélectrique.

4. Transducteur MEMS selon l'une quelconque des revendications précédentes, comprenant en outre un ou plusieurs ports audio disposés dans le matériau diélectrique, les ports audio fournissant une ouverture entre une première surface extérieure de la couche diélectrique et une deuxième surface extérieure du matériau diélectrique.

5. Transducteur MEMS selon la revendication 4, dans lequel au moins un port audio traverse l'électrode (15), et dans lequel une partie de l'électrode est exposée au niveau d'une surface intérieure d'un port audio, la partie exposée de l'électrode agissant pour éliminer une charge indésirable pendant l'utilisation.

6. Procédé de formation d'un transducteur à système mécanique micro-électrique (MEMS), le procédé comprenant les étapes suivantes :

dépôt d'une première couche de matériau diélectrique ;

dépôt d'une électrode ; **caractérisé par**
le dépôt d'une deuxième couche de matériau diélectrique, de telle façon que la première couche de matériau diélectrique et la deuxième couche de matériau diélectrique sont disposées sur des côtés opposés de l'électrode ; et dans lequel l'étape de dépôt de la première couche de matériau diélectrique comprend la formation :

d'une première impédance dans un premier plan s'étendant substantiellement orthogonalement au plan de la première couche ; et
d'une deuxième impédance dans un deuxième plan le deuxième plan comprenant un plan d'étendant substantiellement parallèlement au premier plan ;
dans lequel la première impédance est réduite par rapport à la deuxième impédance, de telle façon que lorsqu'elle est sollicitée pendant l'utilisation, la première couche de matériau diélectrique fonctionne dans un mode de fonctionnement de tunnelisation pour fournir un chemin de fuite éliminant une charge indésirable de la couche de matériau diélectrique lorsqu'il est utilisé.

7. Procédé selon la revendication 6, dans lequel l'étape de dépôt de la première couche de matériau diélectrique comprend l'étape de dépôt d'une couche de matériau diélectrique présentant une épaisseur réduite par rapport à la deuxième couche de matériau diélectrique.

8. Procédé selon la revendication 6 ou 7, dans lequel la composition de la première couche est différente de la composition de la deuxième couche.

9. Procédé selon l'une quelconque des revendications 6 à 8, comprenant en outre l'étape de formation d'un ou de plusieurs ports audio s'étendant à travers les première et deuxième couches de matériau diélectrique, dans lequel l'étape de formation d'un ou de plusieurs ports audio comprend la formation d'au moins un port audio à travers l'électrode, et dans lequel l'étape de formation d'un port audio à travers l'électrode comprend l'exposition d'une partie de l'électrode, la partie exposée de l'électrode agissant pour éliminer une charge indésirable lors de son utilisation.

10. Dispositif électronique ou dispositif de communication ou téléphone portable ou dispositif audio ou dispositif informatique ou véhicule ou dispositif médical ou dispositif industriel comprend un transducteur à système mécanique micro-électrique (MEMS) selon l'une quelconque des revendications 1 à 5.

Figure 1

Figure 2

Figure 3

Figure 4

Figure 5

Figure 6

Figure 7

Figure 8

Figure 9

Figure 10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- Effects of Electrical Leakage Currents on MEMS Reliability and Performance. **ARNEY et al.** IEEE Transactions on device and materials reliability. IEEE service center, 01 June 2004, vol. 4, 198-207